# EUROPÄISCHE PATENTSCHRIFT

(11) **EP 0 764 975 B1**
(45) Veröffentlichungstag und Bekanntmachung des Hinweises auf die Patenterteilung: **14.01.1998**
(21) Anmeldenummer: 96114574.5
(22) Anmeldetag: 12.09.1996
(51) Int. Cl.: H01L 21/304, H01L 21/322

(54) **Verfahren zur Erzeugung einer stapelfehlerinduzierenden Beschädigung auf der Rückseite von Halbleiterscheiben**
Process for producing superficial piling-up defects on the backside of semiconductor wafers
Procédé de création de défauts d'empilement superficiels dans des plaquettes semi-conductrices sur la face arrière

(30) Priorität: 14.09.1995 DE 19534080
(43) Veröffentlichungstag der Anmeldung: 26.03.1997
(73) Patentinhaber: Wacker Siltronic Gesellschaft für Halbleitermaterialien Aktiengesellschaft, 84489 Burghausen (DE)
(72) Erfinder: Brehm, Gerhard, Dr., 84533 Haiming (DE); Mayrhuber, Rudolf, 5121 Ostermiething (AT); Niedermeier, Johann, 84508 Burgkirchen (DE)
(74) Vertreter: Rimböck, Karl-Heinz, Dr.

(56) Entgegenhaltungen:
- EP-A- 0 362 516
- US-A- 3 905 162
- US-A- 4 144 099
- US-A- 4 587 771
- US-A- 5 164 323

## Beschreibung

Die Erfindung betrifft ein Verfahren zur Erzeugung einer stapelfehlerinduzierenden Beschädigung auf der Rückseite von Halbleiterscheiben durch Behandlung der Rückseite mit losen Hartstoffteilchen, die in einer Flüssigkeit suspendiert sind. Ziel der absichtlichen Beschädigung ("Damage") der Rückseite von Halbleiterscheiben ist die Erzeugung von Stapelfehlern, die als sogenannte getterfähige Zentren in der Lage sind, Punktdefekte von elektronischen Bauelementen auf der Vorderseite der Halbleiterscheibe fernzuhalten. Die Punktdefekte, zu denen auch störende Fremdatome zählen, werden durch die induzierten Stapel fehler von der Vorderseite der Halbleiterscheibe weggezogen und gebunden ("Getter-Effekt"). Es sind verschiedene Methoden bekannt geworden, mit denen die gewünschte Beschädigung der Rückseite einer Halbleiterscheibe erreicht werden kann. Gemäß der Offenbarung der US-3,905,162 ist beispielsweise versucht worden, die Rückseite einer Halbleiterscheibe gezielt zu verkratzen. In der US-5,164,323 wird von anderen Damage-Verfahren berichtet, beispielsweise von einem Verfahren, bei dem die Halbleiterscheibe zeitweise in ein Bad von fluidisierten Schleifkörnern gestellt wird oder von einem Verfahren, bei dem die Rückseite der Halbleiterscheibe einer Druckbelastung durch die abtragsfreie Einwirkung eines elastischen Druckübertragungsmediums unterworfen wird, welches lokale Druckinhomogenitäten hervorruft.

US-A-4587771 offenbart ein Verfahren zur Erzeugung von Defekten, bei dem die Rückseite eines Wafers durch Hartstoffteilchen in einer elastischen Oberfläche einer Walze behandelt wird.

Unter der Bezeichnung "wet blast" ist ein Verfahren bekannt geworden, bei dem ein Strahl einer Suspension im wesentlichen senkrecht gegen die Rückseite der Halbleiterscheibe gerichtet wird. Dieses Verfahren und alle Methoden, bei denen die Rückseite der Halbleiterscheibe durch die Einwirkung von losem oder gebundenem Korn oder mechanischen Werkzeugen aufgerauht wird und dabei einer senkrecht zur Oberfläche der Rückseite wirkenden Kraft ausgesetzt ist, zeigen schwerwiegende Nachteile. Im Verlauf der Herstellung der elektronischen Bauelemente auf der Vorderseite der Halbleiterscheibe entsteht eine immer größer werdende Anzahl unerwünschter Partikel, die den Ausfall ganzer Bauelementgruppen verursachen kann. Die Partikel lösen sich von der in der beschriebenen Weise aufgerauhten Rückseite der Halbleiterscheibe. Bei manchen Verfahren ist die mechanische Beschädigung der Rückseite so stark, daß sich die Halbleiterscheibe durchbiegt. Die Integration elektronischer Bauelemente auf der Vorderseite der Halbleiterscheibe erfordert jedoch Halbleiterscheiben mit möglichst ebenen Seitenflächen. Darüber hinaus ist bei der Beschädigung der Rückseite der Halbleiterscheibe durch in bezug auf Größe und Richtung nahezu undefinierte Krafteinwirkung nicht zu vermeiden, daß die induzierten Stapelfehler inhomogen verteilt sind und elektronische Bauelemente ausfallen, weil die Wirkung des Getter-Effekts in ihrer Umgebung mangelhaft ist.

Die vorliegende Erfindung hat zur Aufgabe, ein Damage-Verfahren anzugeben, bei dem die induzierten Stapelfehler homogen verteilt sind und eine zur Generierung unerwünschter Partikel führende Aufrauhung der Rückseite der Halbleiterscheibe vermieden wird. Außerdem sollen nach dem Verfahren behandelte Halbleiterscheiben ihre ursprüngliche, ebene Form behalten.

Gelöst wird die Aufgabe durch ein Verfahren zur Erzeugung einer stapelfehlerinduzierenden Beschädigung auf der Rückseite von Halbleiterscheiben durch Behandlung der Rückseite mit losen Hartstoffteilchen, die in einer Flüssigkeit suspendiert sind, dadurch gekennzeichnet, daß die Rückseite einer Halbleiterscheibe mit den suspendierten Hartstoffteilchen in Kontakt gebracht wird und die Hartstoffteilchen tangential zur Rückseite bewegt werden, wobei sie auf die Rückseite der Halbleiterscheibe Kräfte ausüben, die im wesentlichen nur tangential gerichtete Komponenten aufweisen.

Nach der Behandlung der Halbleiterscheibe ist eine mechanische Beschädigung der Rückseite auch bei Betrachtung unter einem Mikroskop im Licht einer die Rauhigkeit von Oberflächen aufdeckenden "Haze-Lampe" nicht festzustellen. Die induzierten Stapelfehler, die homogen verteilt sind, werden erst nach einer Testoxidation und dem Anätzen der Rückseite sichtbar. In die Vorderseite der erfindungsgemäß behandelten Halbleiterscheibe können die vorgesehenen elektronischen Bauelemente integriert werden, ohne daß von der Rückseite der Halbleiterscheibe kontaminierende Partikel abgesondert werden.

Der Erfolg des Verfahrens liegt darin begründet, daß auf eine mechanische Krafteinwirkung, die hauptsächlich senkrecht gegen die Rückseite der Halbleiterscheibe gerichtet ist, verzichtet wird. Stattdessen erfolgt eine Krafteinwirkung, die im wesentlichen tangential zur Rückseite der Halbleiterscheibe gerichtet ist. Das Damage wird im Gegensatz zu bekannten Verfahren lediglich durch geringfügige, in der Ebene der Rückseite der Halbleiterscheibe wirkende Scherkräfte erzeugt, die von der Flüssigkeit auf die darin suspendierten Hartstoffteilchen übertragen werden. Die Beschädigung auf der Rückseite der Halbleiterscheibe beschränkt sich daher auf die Erzeugung eines mechanischen Spannungsfeldes, mit dem keine makroskopische Zerstörung der Oberfläche einhergeht.

Die in einer Flüssigkeit suspendierten Hartstoffteilchen ("Slurry") werden als dünner Film auf die Rückseite der Halbleiterscheibe aufgebracht und tangential über die Scheibenoberfläche bewegt. Die Wechselwirkung zwischen den suspendierten Hartstoffteilchen und der Rückseite der Halbleiterscheibe wird vorzugsweise von einer Walzenanordnung vermittelt, die mindestens eine sich drehende Walze mit einer elastischen Oberfläche umfaßt. Durch die Walzendrehung werden die suspendierten Hartstoffteilchen zwischen die Walze und die Rückseite der Halbleiterscheibe transportiert. Gleichzeitig wird die Halbleiterscheibe fast kraftfrei an der sich drehenden Walze vorbeigeführt. Bei diesem Vorgang bauen sich zwischen der Walze und der Rückseite der Halbleiterscheibe tangential gerichtete Scherkräfte auf, die von der Flüssigkeit auf die Hartstoffteilchen übertragen werden. Wegen ihrer elastischen Oberfläche ist die Walze ohne die Zuführung der suspendierten Hartstoffteilchen nicht in der Lage, eine stapelfehlerinduzierende Beschädigung auf der Rückseite der Halbleiterscheibe hervorzurufen.

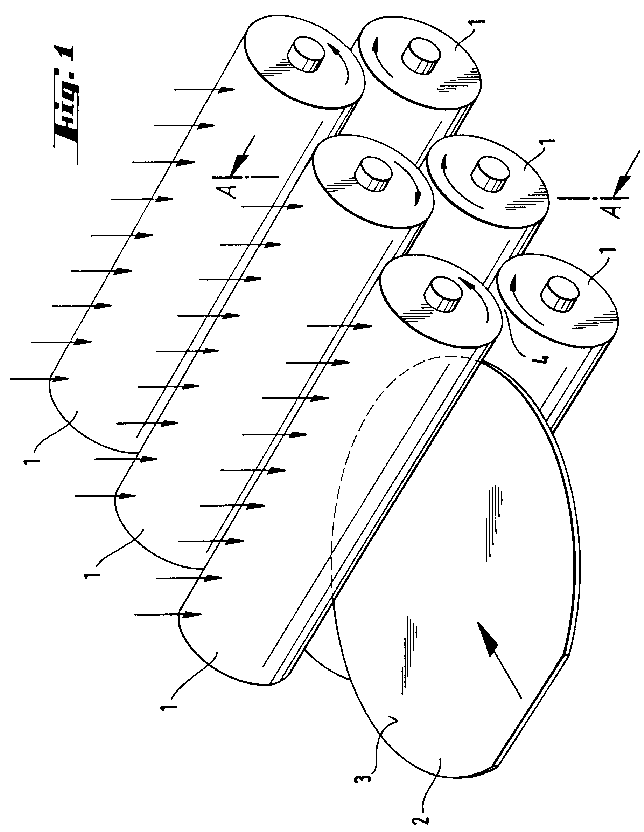

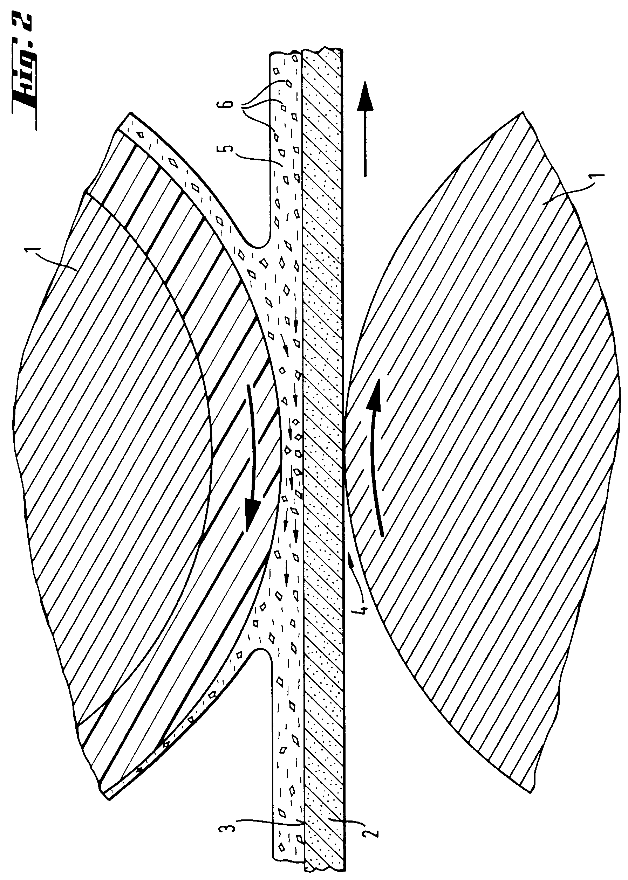

Nachfolgend wird die Erfindung an Hand von zwei Figuren näher erläutert. Figur 1 zeigt schematisch das Beispiel einer möglichen Walzenanordnung mit zwei sich gegenüberliegenden Lagen von je drei Walzen 1. Die Halbleiterscheibe 2 wird mit nach oben zeigender Rückseite 3 durch den Spalt 4, der zwischen den beiden Walzen-Lagen besteht, transportiert. Die in der Flüssigkeit suspendierten Hartstoffteilchen werden gleichmäßig verteilt auf die obere Walzen-Lage aufgetragen (ist durch senkrechte Pfeile dargestellt) und gelangen in Folge der Walzendrehung auf die Rückseite 3 der Halbleiterscheibe 2. Das Slurry bildet dabei einen Film auf der Rückseite der Halbleiterscheibe, in dem sich, hervorgerufen durch die Bewegung der Walzen 1 und der Halbleiterscheibe 2, Scherkräfte aufbauen, die im wesentlichen tangential zur Rückseite der Scheibe gerichtet sind. Die Hartstoffteilchen, auf die diese Kräfte übertragen werden, erzeugen schließlich die beabsichtigte, stapelfehlerinduzierende Beschädigung auf der Rückseite der Halbleiterscheibe. Figur 2 zeigt die schematische Darstellung eines Schnittes durch die Vorrichtung entlang der Schnittlinie A-A in Figur 1. Im Spalt 4 zwischen der Rückseite 3 der Halbleiterscheibe 2 und der ihr gegenüberliegenden Walze 1 befindet sich der Slurryfilm aus Flüssigkeit 5 und Hartstoffteilchen 6.

Die Walzen der unteren Lage fungieren lediglich als Transportwalzen. Sie können daher beispielsweise auch durch ein Transportband ersetzt sein, auf das die Halbleiterscheibe mit ihrer Vorderseite aufgelegt wird.

Damit die suspendierten Hartstoffteilchen in der vorgesehenen Weise wirken können, muß zumindest die Oberfläche der Walzen, die die Hartstoffteilchen auf die Rückseite der Halbleiterscheibe bringen, aus einem elastischen Material gefertigt sein. Dadurch wird verhindert, daß über die Walzen Kräfte auf die Hartstoffteilchen übertragen werden, die im wesentlichen senkrecht gegen die Rückseite der Halbleiterscheibe gerichtet sind. Das Walzenmaterial sollte daher vorzugsweise aus einem elastischen Kunststoff, beispielsweise aus Polyurethan (PU) oder Polyvinylacetat (PVA) bestehen. Grundsätzlich ist jeder elastische Kunststoff geeignet.

Die Hartstoffteilchen bestehen vorzugsweise aus Aluminiumoxid, Quarz, Siliciumcarbid, Zirkonoxid oder Gemischen dieser Stoffe. Der mittlere Durchmesser der Teilchen beträgt bevorzugt 2 bis 150 µm, besonders bevorzugt 2 bis 40 µm. Die Hartstoffteilchen werden vorzugsweise in Wasser oder einer wässerigen Flüssigkeit suspendiert, die neben Wasser auch Suspendierhilfsstoffe und Tenside enthalten kann.

Es hat sich gezeigt, daß die flächenbezogene Stapelfehlerdichte, die mit dem Verfahren erzielt werden kann, von einer Reihe von Parametern abhängig ist und durch Variation eines oder mehrerer Parameter gezielt eingestellt werden kann. Zu diesen Parametern gehören insbesondere die Konzentration der Hartstoffteilchen in der Suspension, die Elastizität der Walzenoberfläche, die Drehzahl der Walze bei der Drehbewegung und die Behandlungsdauer, während der die suspendierten Hartstoffteilchen auf die Rückseite der Halbleiterscheibe einwirken. Das Verfahren wird daher am besten durch Vorversuche, bei denen die genannten Parameter systematisch variiert werden, optimiert und zweckmäßigerweise auf eine flächenbezogene Stapelfehlerdichte von 1*10⁵ bis 1*10⁶ Stapelfehler/cm² abgestimmt.

### Beispiel:

Halbleiterscheiben aus Silicium mit einem Durchmesser von 125 mm und geätzten Oberflächen wurden in einer, der Figur entsprechenden Walzenanordnung erfindungsgemäß behandelt. Als Slurry wurde eine Suspension von Al₂O₃-Teilchen (mit einem mittleren Durchmesser von 15 µm) in Wasser verwendet, der zusätzlich ein Suspendierhilfsstoff zugesetzt war. Die Konzentration der Partikel betrug 4,8 % bezogen auf das Volumen der Suspension. Während der Behandlungsdauer von 10 s wurde die Suspension mit einem Volumenstrom von 10 l/min auf die sich mit einer Drehzahl von 100 min⁻¹ drehenden, oben liegenden Walzen gleichmäßig verteilt. Die Oberfläche der Walzen bestand aus einer elastischen Auflage aus PVA. Der Walzendurchmesser betrug 30 mm.

Die Rückseiten der behandelten Halbleiterscheiben wiesen keine unter dem Mikroskop im Licht einer Haze-Lampe sichtbaren, mechanischen Beschädigungen auf. Ein anschließend durchgeführter Stapelfehler-Test ergab eine Dichte induzierter Stapelfehler von 1,5∗10⁵ cm⁻² in homogener Verteilung. Die aus dem Stand der Technik bekannten, nachteiligen Erscheinungen traten bei den getesteten Halbleiterscheiben nicht auf.

## Patentansprüche

1. Verfahren zur Erzeugung einer stapelfehlerinduzierenden Beschädigung auf der Rückseite von Halbleiterscheiben durch Behandlung der Rückseite mit losen Hartstoffteilchen, die in einer Flüssigkeit suspendiert sind, wobei
die Rückseite einer Halbleiterscheibe mit den suspendierten Hartstoffteilchen in Kontakt gebracht wird und die Hartstoffteilchen tangential zur Rückseite bewegt werden, wobei sie auf die Rückseite der Halbleiterscheibe Kräfte ausüben, die im wesentlichen nur tangential gerichtete Komponenten aufweisen.

2. Verfahren nach Anspruch 1, dadurch gekennzeichnet, daß die Hartstoff-Partikel einen mittleren Durchmesser von 2 bis 150 µm aufweisen und aus einem Material bestehen, das aus einer Gruppe ausgewählt ist, die Al₂O₃, SiO₂, SiC, ZrO₂ und deren Gemische umfaßt.

3. Verfahren nach Anspruch 1 oder Anspruch 2, dadurch gekennzeichnet, daß die Flüssigkeit aus einer Gruppe ausgewählt ist, die Wasser und wässerige Lösungen umfaßt.

4. Verfahren nach einem der Ansprüche 1 bis 3, dadurch gekennzeichnet, daß die suspendierten Hartstoffteilchen mit Hilfe mindestens einer sich drehenden Walze mit einer Oberfläche aus elastischem Material auf die Rückseite der Halbleiterscheibe aufgebracht und im wesentlichen tangential zur Rückseite der Halbleiterscheibe bewegt werden.

5. Verfahren nach Anspruch 4, dadurch gekennzeichnet, daß die Dichte der induzierten Stapelfehler in Abhängigkeit mindestens eines Parameters gezielt eingestellt wird, wobei der Parameter einer Gruppe angehört, die die Konzentration der Hartstoffteilchen in der Flüssigkeit, die Elastizität der Walzenoberfläche, die Drehzahl der Walze bei der Drehbewegung und die Behandlungsdauer umfaßt, während der die suspendierten Hartstoffteilchen auf die Rückseite der Halbleiterscheibe einwirken.

## Claims

1. Method for the generation of stacking-fault-induced damage on the back of semiconductor wafers by treating the back with loose hard-material particles which are suspended in a liquid, the back of a semiconductor wafer being brought into contact with the suspended hard-material particles and the hard-material particles being propelled tangentially to the back, under which circumstances they exert on the back of the semiconductor wafer forces which have essentially only tangentially directed components.

2. Method according to Claim 1, characterized in that the hard-material particles have a mean diameter of 2 to 150 µm and are composed of a material which is selected from a group comprising Al₂O₃, SiO₂, SiC, ZrO₂ and mixtures thereof.

3. Method according to Claim 1 or Claim 2, characterized in that the liquid is selected from a group comprising water and aqueous solutions.

4. Method according to any of Claims 1 to 3, characterized in that the suspended hard-material particles are applied to the back of the semiconductor wafer with the aid of at least one rotating roll having a surface composed of elastic material and are propelled essentially tangentially to the back of the semiconductor wafer.

5. Method according to Claim 4, characterized in that the induced stacking-fault density is varied systematically as a function of at least one parameter, the parameter belonging to a group comprising the concentration of the hard-material particles in the liquid, the elasticity of the roll surface, the rotary speed of the roll during the rotational movement and the treatment time during which the suspended hard-material particles act on the back of the semiconductor wafer.

## Revendications

1. Procédé destiné à produire des dommages induisant des défauts d'empilement sur la face arrière de plaquettes semi-conductrices par traitement de la face arrière au moyen de particules de substances dures libres qui sont en suspension dans un liquide, la face arrière d'une plaquette semi-conductrice étant amenée en contact avec des particules de substances dures en suspension et les particules de substances dures étant mues tangentiellement à la face arrière, sachant qu'elles exercent sur la face arrière de la plaquette semi-conductrice des forces qui ne présentent principalement que des composantes dirigées tangentiellement.

2. Procédé suivant la revendication 1, caractérisé en ce que les particules de substances dures ont un diamètre moyen de 2 à 150 µm et sont en une matière choisie dans un groupe comprenant l'Al₂O₃, le SiO₂, le SiC, le ZrO₂ et leurs mélanges.

3. Procédé suivant la revendication 1 ou 2, caractérisé en ce que le liquide est choisi dans un groupe qui comprend l'eau et les solutions aqueuses.

4. Procédé suivant l'une quelconque des revendications 1 à 3, caractérisé en ce que les particules de substances dures en suspension sont appliquées sur la face arrière de la plaquette semi-conductrice à l'aide d'au moins un cylindre rotatif ayant une surface en matière élastique et sont mues essentiellement tangentiellement à la face arrière de la plaquette semi-conductrice.

5. Procédé suivant la revendication 4, caractérisé en ce que la densité des défauts d'empilement induits est réglée systématiquement en fonction d'au moins un paramètre, le paramètre appartenant à un groupe comprenant la concentration des particules de substances dures dans le liquide, l'élasticité de la surface du cylindre, la vitesse de rotation du cylindre au cours du mouvement de rotation et la durée de traitement pendant laquelle les particules de substances dures agissent sur la face arrière de la plaquette semi-conductrice.
